(19) **Europäisches Patentamt European Patent Office Office européen des brevets**

(11) **EP 3 553 801 A1**

(12) **EUROPEAN PATENT APPLICATION**
published in accordance with Art. 153(4) EPC

(43) Date of publication:
**16.10.2019 Bulletin 2019/42**

(21) Application number: **17878408.8**

(22) Date of filing: **16.11.2017**

(51) Int Cl.:
**H01F 41/04** *(2006.01)*    **H01F 17/00** *(2006.01)*
**H05K 1/16** *(2006.01)*    **H05K 3/20** *(2006.01)*

(86) International application number:
**PCT/JP2017/041229**

(87) International publication number:
**WO 2018/105348 (14.06.2018 Gazette 2018/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **07.12.2016 JP 2016237740**
                **06.11.2017 JP 2017213828**

(71) Applicant: **Nitto Denko Corporation Ibaraki-shi, Osaka 567-8680 (JP)**

(72) Inventors:
• **FURUKAWA, Yoshihiro**
  **Ibaraki-shi**
  **Osaka 567-8680 (JP)**
• **OKUMURA, Keisuke**
  **Ibaraki-shi**
  **Osaka 567-8680 (JP)**

(74) Representative: **Grünecker Patent- und Rechtsanwälte PartG mbB Leopoldstraße 4 80802 München (DE)**

(54) **METHOD FOR MANUFACTURING MODULE**

(57)    A method for producing a module includes a first step of preparing a seed layer disposed at a one-side surface in a thickness direction of a first peeling layer, a second step of forming a conductive pattern at a one-side surface in the thickness direction of the seed layer by plating allowing electric power to be supplied from the seed layer, a third step of pushing the conductive pattern into a first adhesive layer containing a first magnetic particle, and a fourth step of exposing the other-side surfaces in the thickness direction of the conductive pattern and the first adhesive layer.

FIG. 2A
First step

FIG. 2B

FIG. 2C

FIG. 2D
Second step

FIG. 2E

FIG. 2F
Third step

FIG. 2G
Fourth step (Fifth step)

FIG. 2H
Sixth step (Seventh step)

**Description**

TECHNICAL FIELD

The present invention relates to a method for producing a module.

BACKGROUND ART

Conventionally, it has been known that a module that combines a coil with a magnetic material is used in wireless power transmission (wireless power feeding), wireless communication, a passive component, or the like.
For example, a planar inductor in which both surfaces of a spiral-shaped conductor coil or a laminate thereof are sandwiched by a ferromagnetic layer via an insulating layer has been known.
In order to produce the planar inductor of Patent Document 1, a Cu foil is applied to both surfaces of a first insulating layer made of a polyimide film, and next, the Cu foils on both surfaces are etched, so that the spiral-shaped conductor coil is processed (subtractive method). Next, two second insulating layers made of the polyimide film are disposed, and subsequently, the ferromagnetic layer is disposed.

Citation List

Patent Document

Patent Document 1: Japanese Unexamined Patent Publication No. H1-318212

SUMMARY OF THE INVENTION

PROBLEM TO BE SOLVED BY THE INVENTION

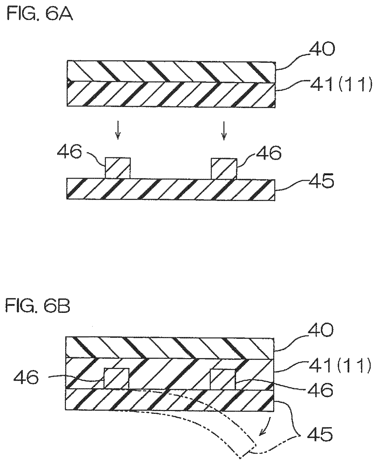

Recently, the thinning of various modules has been required. However, there is a disadvantage that the planar inductor obtained by the method described in Patent Document 1 includes the first insulating layer, so that the above-described demand cannot be satisfied.
In the inductor obtained by the method described in Patent Document 1, there is a disadvantage that the ferromagnetic layer faces the spiral-shaped conductor coil via the second insulating layer, so that the above-described demand cannot be satisfied, and additionally, it is difficult to ensure high inductance.
Meanwhile, it is considered that the spiral-shaped conductor coil that is processed by the subtractive method without the above-described second insulating layer is directly covered with the ferromagnetic layer.
For example, as shown in FIG. 6A, spiral-shaped conductor coils 46 are formed on the upper surface of a peeling layer 45 by a subtractive method, and a ferromagnetic layer 41 is disposed on the lower surface of a peeling layer 40. As shown in FIG. 6B, next, the peeling layer 45 is press-bonded to the ferromagnetic layer 41, so that the spiral-shaped conductor coils 46 are sunk into the ferromagnetic layer 41. Thereafter, as shown by a phantom line of FIG. 6B, the peeling layer 45 is peeled from the ferromagnetic layer 41 and the spiral-shaped conductor coil 46.
However, there is a disadvantage that the ferromagnetic layer 41 requires the pressure-sensitive adhesive properties, so that the above-described peeling cannot be surely and smoothly performed.
An object of the present invention is to provide a method for producing a module that is capable of surely and smoothly producing a module which can ensure high inductance, while the thinning thereof is achieved.

MEANS FOR SOLVING THE PROBLEM

The present invention (1) includes a method for producing a module including a first step of preparing a seed layer disposed at a one-side surface in a thickness direction of a first peeling layer, a second step of forming a conductive pattern at a one-side surface in the thickness direction of the seed layer by plating allowing electric power to be supplied from the seed layer, a third step of pushing the conductive pattern into a first adhesive layer containing a first magnetic particle, and a fourth step of exposing the other-side surfaces in the thickness direction of the conductive pattern and the first adhesive layer.
According to the method for producing a module, a module without including the first insulating layer such as that in Patent Document 1 can be produced. Thus, a thin module can be produced.
In the third step of the method for producing a module, the conductive pattern is pushed into the first adhesive layer containing the first magnetic particle, so that the high inductance can be ensured, while further thinning of the module can be achieved.

Furthermore, in the method for producing a module, in the third step, the conductive pattern that is formed at the one-side surface in the thickness direction of the seed layer is pushed into the first adhesive layer, and at this time, even though the one-side surface in the thickness direction of the seed layer pressure-sensitively adheres to the first adhesive layer, in the fourth step, when the first peeling layer is peeled from the seed layer, and the seed layer is etched, the other-side surfaces in the thickness direction of the conductive pattern and the first adhesive layer can be surely and smoothly exposed.

The present invention (2) includes the method for producing a module described in (1), wherein in the third step, the seed layer is press-bonded to the first adhesive layer, and the conductive pattern is pushed into the first adhesive layer, and the fourth step includes a fifth step of peeling the first peeling layer from the seed layer and a sixth step of removing the seed layer.

According to the method for producing a module, in the third step, even though the seed layer is press-bonded to the first adhesive layer, and the seed layer pressure-sensitively adheres to the first adhesive layer, in the fifth step, the first peeling layer is peeled from the seed layer, and in the sixth step, the seed layer is removed, so that the other-side surfaces in the thickness direction of the conductive pattern and the first adhesive layer can be further more surely and smoothly exposed.

The present invention (3) includes the method for producing a module described in (2), wherein in the sixth step, the seed layer is etched.

According to the method for producing a module, in the third step, the conductive pattern that is formed at the one-side surface in the thickness direction of the seed layer is pushed into the first adhesive layer, and at this time, even though the one-side surface in the thickness direction of the seed layer is in tight contact with the first adhesive layer, in the sixth step, the seed layer is etched, so that the seed layer is surely and smoothly removed, and the other-side surfaces in the thickness direction of the conductive pattern and the first adhesive layer can be further more surely and smoothly exposed.

The present invention (4) includes the method for producing a module described in any one of (1) to (3), wherein the content ratio of the first magnetic particle in the first adhesive layer is 15 volume% or more and 80 volume% or less.

According to the method for producing a module, the content ratio of the first magnetic particle in the first adhesive layer is 15 volume% or more, so that the improvement of the inductance can be achieved. Also, the content ratio of the first magnetic particle in the first adhesive layer is 80 volume% or less, so that the push-in of the conductive pattern with respect to the first adhesive layer can be surely performed. Thus, both of the improvement of the inductance and the improvement of the push-in properties of the conductive pattern with respect to the first adhesive layer can be achieved.

The present invention (5) includes the method for producing a module described in any one of (1) to (4), wherein a first resin component is an epoxy resin, a phenol resin, and an acrylic resin.

According to the method for producing a module, the first resin component is the epoxy resin, the phenol resin, and the acrylic resin, so that in the third step, the conductive pattern can be surely pushed into the first adhesive layer, and a module having excellent flexibility and excellent heat resistance can be produced.

The present invention (6) includes the method for producing a module described in any one of (1) to (5) further including a seventh step of disposing a magnetic layer containing a second magnetic particle and a second resin component at the other-side surface in the thickness direction of the first adhesive layer.

According to the method for producing a module, in the seventh step, the magnetic layer is disposed on the other-side surface in the thickness direction of the first adhesive layer, so that the inductance of the module can be further more improved.

The present invention (7) includes the method for producing a module described in any one of (1) to (5) further including an eighth step of forming an adhesive layer including the first adhesive layer and the second adhesive layer and embedding the conductive pattern by covering the one-side surface in the thickness direction of the conductive pattern with a second adhesive layer containing the first magnetic particle, wherein the third step is performed so that the one-side surface in the thickness direction of the conductive pattern is exposed from the first adhesive layer.

According to the method for producing a module, in the eighth step, the adhesive layer that embeds the conductive pattern is formed, so that the inductance of the module can be further more improved.

The present invention (8) includes the method for producing a module described in (7), wherein the content ratio of the first magnetic particle in the adhesive layer is 15 volume% or more and 80 volume% or less.

According to the method for producing a module, the content ratio of the first magnetic particle in the adhesive layer is 15 volume% or more, so that the improvement of the inductance can be achieved. Also, the content ratio of the first magnetic particle in the adhesive layer is 80 volume% or less, so that the embedding of the conductive pattern with respect to the adhesive layer can be surely performed. Thus, both of the improvement of the inductance and the embedding properties of the adhesive layer with respect to the conductive pattern can be achieved.

The present invention (9) includes the method for producing a module described in any one of (1) to (8), wherein the first magnetic particle is a particle consisting of at least one kind selected from iron and iron alloy.

According to the method for producing a module, the first magnetic particle is a particle consisting of at least one kind selected from iron and iron alloy, so that the inductance can be surely improved.

The present invention (10) includes the method for producing a module described in (7) or (8) further including a tenth step of disposing the magnetic layer containing the second magnetic particle and the second resin component at the one-side surface and the other-side surface in the thickness direction of the adhesive layer.

According to the method for producing a module, in the tenth step, the magnetic layer is disposed at the one-side surface and the other-side surface in the thickness direction of the adhesive layer, so that the inductance of the module can be further more improved.

The present invention (11) includes the method for producing a module described in (6) or (10), wherein the content ratio of the second magnetic particle in the magnetic layer is 40 volume% or more.

According to the method for producing a module, the content ratio of the second magnetic particle in the magnetic layer is high of 40 volume% or more, so that the improvement of the inductance can be further more achieved by the magnetic layer.

The present invention (12) includes the method for producing a module described in any one of (6), (10), and (11), wherein the second magnetic particle is a particle consisting of at least one kind selected from iron and iron alloy.

According to the method for producing a module, the second magnetic particle is a particle consisting of at least one kind selected from iron and iron alloy, so that the inductance can be surely improved.

The present invention (13) includes the method for producing a module described in any one of (6) and (10) to (12), wherein the second resin component is an epoxy resin, a phenol resin, and an acrylic resin.

According to the method for producing a module, a module having excellent flexibility and excellent heat resistance can be produced.

EFFECT OF THE INVENTION

According to the method for producing a module of the present invention, high inductance is ensured, while the thinning of the module is achieved, and the other-side surfaces in the thickness direction of the conductive pattern and the first adhesive layer can be surely and smoothly exposed.

BRIEF DESCRIPTION OF THE DRAWINGS

FIG. 1 shows a bottom view of a first module obtained by a first embodiment of a method for producing a module of the present invention.

FIGS. 2A to 2H show production process views of a method for producing a first module that is the first embodiment of the method for producing a module of the present invention:

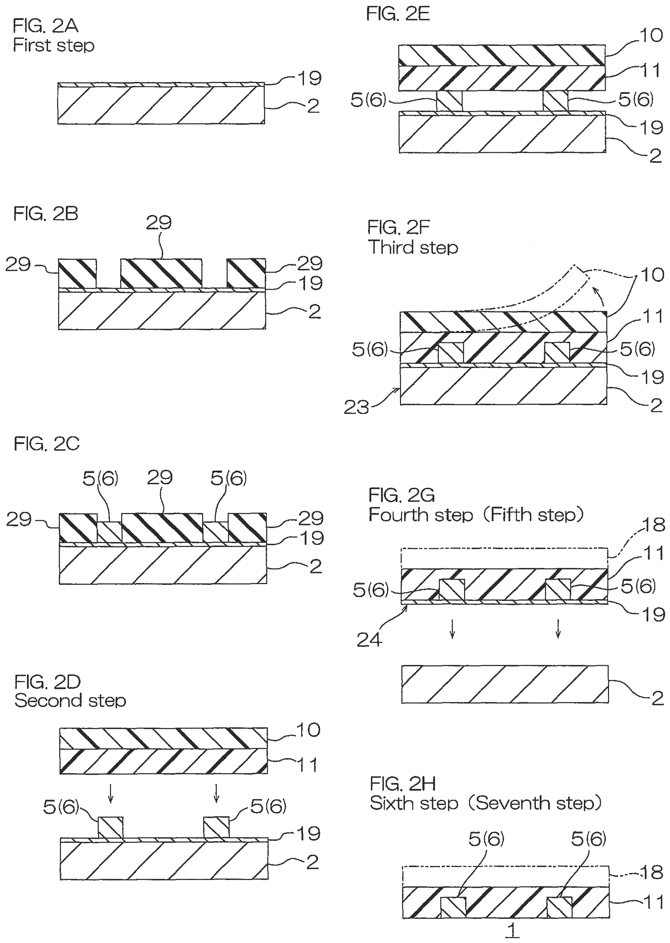

FIG. 2A illustrating a first step of preparing a seed layer disposed on a first peeling layer,
FIG. 2B illustrating a step of disposing a plating resist,
FIG. 2C illustrating a second step of forming a conductive pattern by plating,
FIG. 2D illustrating a step of removing the plating resist,
FIG. 2E illustrating a step of bringing a first adhesive layer into contact with a coil pattern,
FIG. 2F illustrating a third step of pushing the coil pattern into the first adhesive layer,
FIG. 2G illustrating a fifth step of peeling the first peeling layer from the seed layer, and

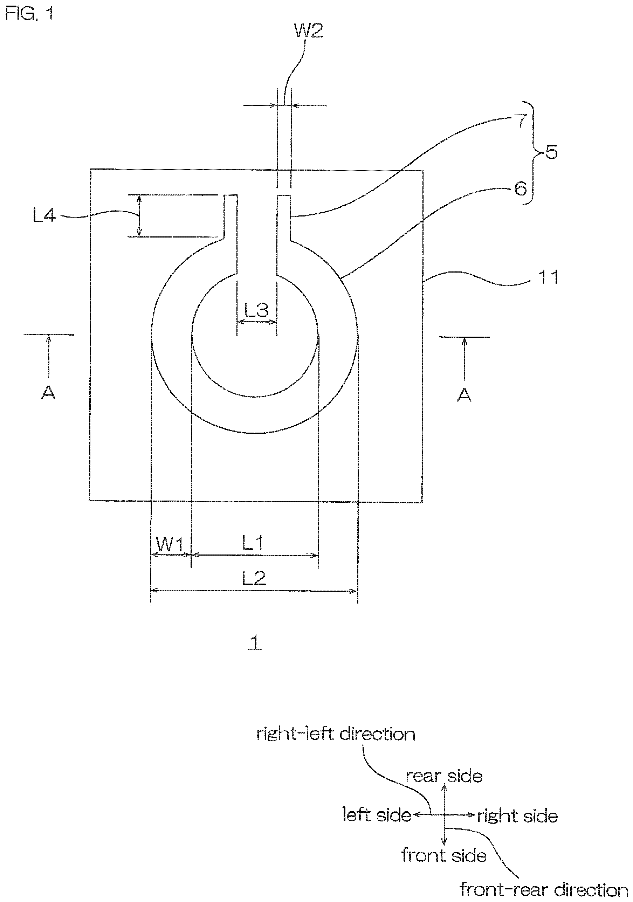

FIG. 2H illustrating a sixth step (cross-sectional view along an A-A line of FIG. 1) of etching the seed layer.

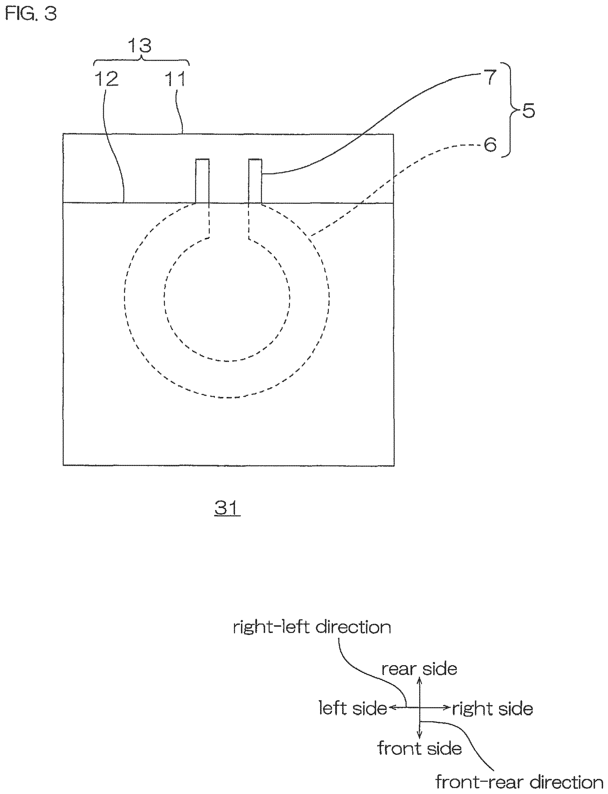

FIG. 3 shows a bottom view of a second module obtained by a second embodiment of the method for producing a module of the present invention.

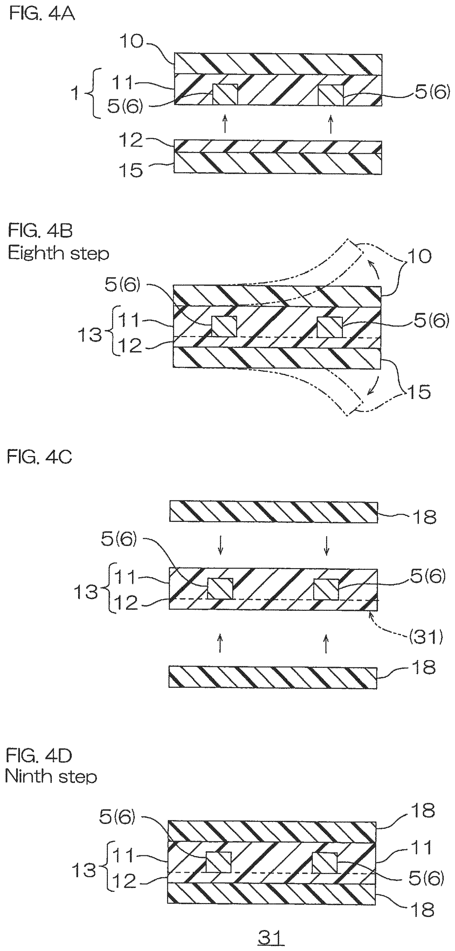

FIGS. 4A to 4D show production process views of a method for producing a second module that is the second embodiment of the method for producing a module of the present invention:

FIG. 4A illustrating a step of preparing a second adhesive layer disposed on a third peeling layer,
FIG. 4B illustrating an eighth step of covering a coil pattern with the second adhesive layer and embedding the coil pattern by an adhesive layer,
FIG. 4C illustrating a step of preparing two magnetic layers, and
FIG. 4D illustrating a ninth step of disposing the magnetic layers on the adhesive layer.

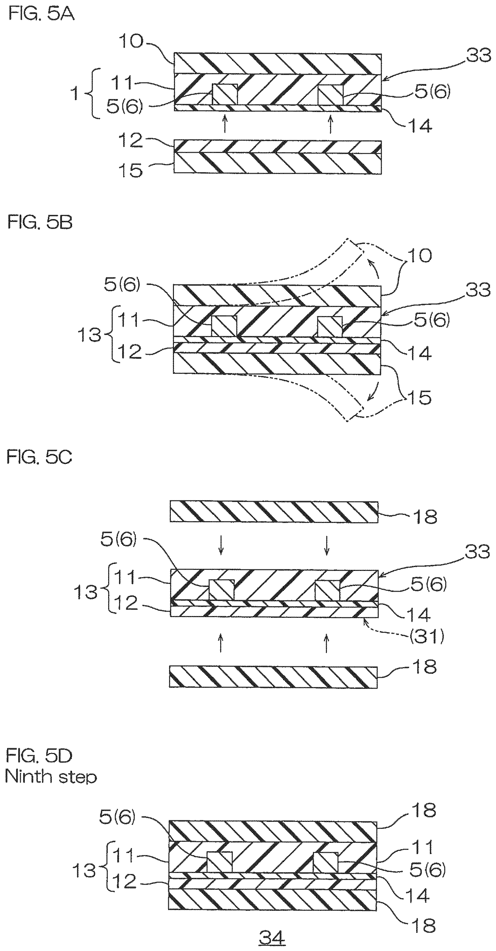

FIGS. 5A to 5D show production process views of a method for producing a third module that is a third embodiment and a fourth module that is a fourth embodiment of the method for producing a module of the present invention:

FIG. 5A illustrating a step of producing the third module by disposing a supporting layer on the lower surface of the first module,
FIG. 5B illustrating an eighth step of covering the supporting layer with the second adhesive layer,
FIG. 5C illustrating a step of preparing two magnetic layers, and
FIG. 5D illustrating a ninth step of disposing the magnetic layers on the adhesive layer.

FIGS. 6A and 6B show production process views of a method for producing a module of Comparative Example 2:

FIG. 6A illustrating a step of preparing a coil pattern disposed on a peeling layer by a subtractive method and
FIG. 6B illustrating a step of pushing the coil pattern into a first adhesive layer.

DESCRIPTION OF EMBODIMENTS

In FIGS. 2A to 2H, the up-down direction on the plane of the sheet is an up-down direction (one example of a thickness direction, first direction), the upper side on the plane of the sheet is an upper side (one side in the thickness direction, one side in the first direction), and the lower side on the plane of the sheet is a lower side (the other side in the thickness direction, the other side in the first direction).

In FIG. 1, and FIGS. 2A to 2H, the right-left direction on the plane of the sheet is a right-left direction (second direction perpendicular to the first direction, width direction), the right side on the plane of the sheet is a right side (one side in the width direction, one side in the second direction), and the left side on the plane of the sheet is a left side (the other side in the width direction, the other side in the second direction).

Meanwhile, in FIG. 1, the up-down direction on the plane of the sheet is a front-rear direction (third direction perpendicular to the first direction and the second direction), the lower side on the plane of the sheet is a front side (one side in the third direction), and the upper side on the plane of the sheet is a rear side (the other side in the third direction).

To be specific, directions are in conformity with direction arrows of each view.

<First Embodiment>

1. Method for Producing First Module

A method for producing a first module 1 that is a first embodiment of a method for producing a module of the present invention is described with reference to FIG. 1, and FIGS. 2A to 2H.

The method for producing the first module 1 includes a first step (ref: FIG. 2A) of preparing a seed layer 19 that is disposed on the upper surface (one example of a one-side surface in the thickness direction) of a first peeling layer 2, a second step (ref: FIG. 2D) of forming a coil pattern 5 as one example of a conductive pattern on the upper surface (one example of the one-side surface in the thickness direction) of the seed layer 19 by plating allowing electric power to be supplied from the seed layer 19, a third step (ref: FIG. 2F) of pushing the coil pattern 5 into a first adhesive layer 11 containing a first magnetic particle, and a fourth step (ref: FIG. 2H) of exposing the lower surfaces (one example of the other-side surface in the thickness direction) of the coil pattern 5 and the first adhesive layer 11. The first step to the fourth step are sequentially performed in this order. Hereinafter, each step is sequentially described.

2. First Step

As shown in FIG. 2A, in the first step, the seed layer 19 that is disposed on the upper surface (one example of the one-side surface in the thickness direction) of the first peeling layer 2 is prepared.

The first peeling layer 2 has a generally flat plate (sheet) shape extending in a plane direction that is perpendicular to the thickness direction (the front-rear direction and the right-left direction in FIG. 1). The first peeling layer 2 is a supporting layer that supports the coil pattern 5 along with the seed layer 19 during the formation of the coil pattern 5 and subsequently, the pushing of the coil pattern 5 into the first adhesive layer 11. The first peeling layer 2 is also a transfer substrate (peeling layer) for transferring the coil pattern 5 onto the first adhesive layer 11 (ref: FIG. 2D).

Examples of a material that forms the first peeling layer 2 include metal and resin, and in view of obtaining excellent strength, a metal is used. Examples of the metal include iron, copper, chromium, nickel, and an alloy thereof. Preferably, an alloy is used, more preferably, stainless steel is used.

The thickness of the first peeling layer 2 is, for example, 1 $\mu$m or more, preferably 10 $\mu$m or more. When the thickness of the first peeling layer 2 is the above-described lower limit or more, the coil pattern 5 and the seed layer 19 can be surely supported.

The thickness of the first peeling layer 2 is, for example, 1000 $\mu$m or less, preferably 100 $\mu$m or less. When the thickness of the first peeling layer 2 is the above-described upper limit or less, the handleability of the first peeling layer 2 is excellent.

The seed layer 19 is disposed on the entire upper surface of the first peeling layer 2. The seed layer 19 has a generally flat plate (sheet) shape extending in the plane direction. The seed layer 19 is an electric power-supply layer at the time of forming the coil pattern 5 by electrolytic plating. Also, the seed layer 19 is a supporting layer that supports the coil pattern 5 along with the first peeling layer 2 during the pushing of the coil pattern 5 into the first adhesive layer 11. The first peeling layer 2 is also a transfer substrate (peeling layer) for transferring the coil pattern 5 onto the first adhesive layer 11 (ref: FIG. 2D).

The seed layer 19 is in contact with the upper surface of the first peeling layer 2. The seed layer 19 is in tight contact with (attached to) the upper surface of the first peeling layer 2 with a low peeling strength (pressure-sensitive adhesive force) PS1 with respect to the upper surface of the first peeling layer 2. The pressure-sensitive adhesive force PS1 of the seed layer 19 with respect to the upper surface of the first peeling layer 2 is, for example, relatively low. Thus, in the fourth step (ref: FIG. 2G), the first peeling layer 2 can be easily peeled from the seed layer 19.

Examples of a material that forms the seed layer 19 include metal such as copper, chromium, gold, silver, platinum, nickel, and an alloy thereof and non-metal such as silicon, oxide thereof, and electrically conductive polymer. Preferably, in view of obtaining high electrically conductive properties, a metal is used, more preferably, copper is used. The seed layers 19 may be a single layer or multiple layers.

The thickness of the seed layer 19 is, for example, 0.01 $\mu$m or more, preferably 0.1 $\mu$m or more, more preferably 0.5 $\mu$m or more. When the thickness of the seed layer 19 is the above-described lower limit or more, in the second step (ref: FIG. 2C), the coil pattern 5 can be surely and quickly formed by the electrolytic plating.

The thickness of the seed layer 19 is, for example, 10 $\mu$m or less, preferably 5 $\mu$m or less, more preferably 2 $\mu$m or less. When the thickness of the seed layer 19 is the above-described upper limit or less, in the fourth step (ref: FIG. 2G), the seed layer 19 can be quickly removed.

The ratio (thickness of the seed layer 19/thickness of the first peeling layer 2) of the thickness of the seed layer 19 to that of the first peeling layer 2 is, for example, 0.001 or more, preferably 0.005 or more, more preferably 0.01 or more. When the above-described ratio is the above-described lower limit or more, the handleability of the first peeling layer 2 is excellent, while the coil pattern 5 can be surely and quickly formed by the electrolytic plating,.

The ratio (thickness of the seed layer 19/thickness of the first peeling layer 2) of the thickness of the seed layer 19 to that of the first peeling layer 2 is, for example, 0.5 or less, preferably 0.1 or less, more preferably 0.05 or less. When the above-described ratio is the above-described upper limit or less, the first peeling layer 2 can surely support the coil pattern 5 and the seed layer 19, while the seed layer 19 can be quickly removed.

To prepare the seed layer 19 that is disposed on the upper surface of the first peeling layer 2, first, the first peeling layer 2 is prepared. Next, for example, the seed layer 19 is formed on the upper surface of the first peeling layer 2 by, for example, sputtering or plating such as electrolytic plating and electroless plating. The seed layer 19 is formed on the upper surface of the first peeling layer 2 by preferably plating, more preferably electrolytic plating.

Alternatively, a laminate including the first peeling layer 2 and the seed layer 19 can be also prepared.

3. Second Step

As shown in FIG. 2D, in the second step, the coil pattern 5 is formed on the upper surface (one example of the one-side surface in the thickness direction) of the seed layer 19 by the plating allowing the electric power to be supplied from the seed layer 19. To be specific, the coil pattern 5 is formed by an additive method.

As shown in FIG. 2B, in the additive method, a plating resist 29 is disposed on the upper surface of the seed layer 19. For example, a photoresist such as dry film resist having a sheet shape is disposed on the entire upper surface of the seed layer 19, and next, the plating resist 29 having a pattern reverse to the coil pattern 5 (ref: FIG. 1) is formed by photo processing.

As shown in FIG. 2C, next, the coil pattern 5 is formed in a portion that is exposed from the plating resist 29 on the upper surface of the seed layer 19 by the plating allowing the electric power to be supplied from the seed layer 19.

To be specific, the first peeling layer 2, the seed layer 19, and the plating resist 29 are, for example, immersed in plating bath, and the electric power is supplied from the seed layer 19. Then, the coil pattern 5 is laminated (formed) in a portion that is exposed from the plating resist 29 on the upper surface of the seed layer 19.

The plating conditions are not particularly limited, and are appropriately adjusted by the kind of the plating bath.

In this manner, the coil pattern 5 is formed in a pattern reverse to the plating resist 29.

Thereafter, as shown in FIG. 2D, the plating resist 29 is removed. For example, the plating resist 29 is peeled with a peeling liquid.

Meanwhile, the seed layer 19 is not removed by the above-described removal of the plating resist 29, and remains on the entire upper surface of the first peeling layer 2.

In this manner, the coil pattern 5 that is disposed on the upper surface of the seed layer 19 is obtained.

As shown in FIG. 1, the coil pattern 5 continuously has a coil portion 6 and a terminal portion 7.

The coil portion 6 has a generally circular ring shape in which the rear end portion thereof is cut out when viewed from the top or a generally rectangular frame shape when viewed from the top. To be specific, for example, the coil portion 6 has a generally C-shape in which the rear side thereof is open when viewed from the top.

The terminal portion 7 has a generally linear shape extending rearwardly from each of the two rear end portions of the coil pattern 5 when viewed from the top.

The size of the coil pattern 5 is not particularly limited. A width W1 of the coil portion 6 is, for example, 20 $\mu$m or more, preferably 50 $\mu$m or more, and for example, 100 mm or less, preferably 1000 $\mu$m or less. An inside dimension (inner diameter) L1 of the coil portion 6 is, for example, 20 $\mu$m or more, preferably 50 $\mu$m or more, and for example, 500 mm or less, preferably 5 mm or less. An outside dimension (outer diameter) L2 of the coil portion 6 is, for example, 60 $\mu$m or more, preferably 150 $\mu$m or more, and for example, 500 mm or less, preferably 5 mm or less. A distance L3 between the two rear end portions in the right-left direction of the coil portion 6 is, for example, 20 $\mu$m or more, preferably 50 $\mu$m or more, and for example, 300 mm or less, preferably 2 mm or less. The cross-sectional area S of the coil pattern 5 is, for example, 20 $\mu$m or more, preferably 2500 $\mu$m or more, and for example, 20 mm$^2$ or less, preferably 0.1 mm$^2$ or less.

A length (width) W2 in the right-left direction of the terminal portion 7 is, for example, 20 $\mu$m or more, preferably 50 $\mu$m or more, and for example, 20 mm or less, preferably 10 mm or less. A length L4 in the front-rear direction of the terminal portion 7 is, for example, 20 $\mu$m or more, preferably 50 $\mu$m or more, and for example, 20 mm or less, preferably 10 mm or less. A gap between the terminal portions 7 that are next to each other is the same as the distance L3 between the rear end portions of the coil portion 6 described above.

4. Third Step

As shown in FIG. 2F, in the third step, the coil pattern 5 is pushed into the first adhesive layer 11.

To be specific, the seed layer 19 is press-bonded to the first adhesive layer 11, and the coil pattern 5 is pushed into the first adhesive layer 11.

As shown in FIG. 2D, in the third step, first, the first adhesive layer 11 is prepared.

The first adhesive layer 11 has a generally flat plate shape extending in the plane direction.

The first adhesive layer 11 contains a first magnetic particle and a first resin component. To be specific, the first adhesive layer 11 is prepared from a first adhesive resin composition containing the first magnetic particle and the first resin component.

Examples of the first magnetic particle include a soft magnetic particle and a ferromagnetic particle, and preferably, a soft magnetic particle is used. An example of the soft magnetic particle includes a particle consisting of at least one kind selected from iron and iron alloy. Examples of the soft magnetic particle include magnetic stainless steel (Fe-Cr-Al-Si alloy) particle, sendust (Fe-Si-Al alloy) particle, permalloy (Fe-Ni alloy) particle, silicon copper (Fe-Cu-Si alloy) particle, Fe-Si alloy particle, Fe-Si-B (-Cu-Nb) alloy particle, Fe-Si-Cr alloy particle, Fe-Si-Cr-Ni alloy particle, Fe-Si-Cr alloy particle, Fe-Si-Al-Ni-Cr alloy particle, ferrite particle (to be specific, Ni-Zn ferrite particle or the like), and carbonyliron particle. Of these, in view of magnetic properties, preferably, a Fe-Si-Cr alloy particle and a Ni-Zn ferrite particle are used. Examples of the soft magnetic particle include the soft magnetic particle described in known documents such as Japanese Unexamined Patent Publications No. 2016-108561, 2016-006853, 2016-6852, and 2016-006163.

As the properties such as shape, holding strength, average particle size, and average thickness of the first magnetic particle, the properties described in the above-described known documents are used.

The volume ratio of the first magnetic particle in the first adhesive layer 11 is, for example, 15 volume% or more, preferably 20 volume% or more, more preferably 30 volume% or more, further more preferably 40 volume% or more. When the volume ratio of the first magnetic particle is the above-described lower limit or more, the improvement of the inductance of the first module 1 can be achieved. The volume ratio of the first magnetic particle in the first adhesive layer 11 is, for example, 80 volume% or less, preferably 70 volume% or less, more preferably 65 volume% or less, further more preferably 60 volume% or less. When the volume ratio of the first magnetic particle is the above-described upper limit or less, the push-in of the coil pattern 5 with respect to the first adhesive layer 11 can be surely performed, and the film-forming properties of the first adhesive resin composition are excellent.

The mass ratio of the first magnetic particle in the first adhesive layer 11 is, for example, 44 mass% or more, preferably 53 mass% or more, more preferably 66 mass% or more, further more preferably 75 mass% or more. When the mass ratio of the first magnetic particle is the above-described lower limit or more, the improvement of the inductance of the first module 1 can be achieved.

The mass ratio of the first magnetic particle in the first adhesive layer 11 is, for example, 96 mass% or less, preferably 94 mass% or less. When the mass ratio of the first magnetic particle is the above-described upper limit or less, the improvement of the pressure-sensitive adhesive properties of the first adhesive layer 11 can be achieved, and the film-forming properties of the first adhesive resin composition are excellent.

As the first resin component, for example, the resin component described in the above-described known document is used. These resin components can be used alone or in combination of two or more. Preferably, an epoxy resin, a phenol resin, and an acrylic resin are used in combination. When the epoxy resin, the phenol resin, and the acrylic resin are used in combination as the first resin component, the coil pattern 5 can be surely pushed into the first adhesive layer 11, and excellent flexibility and excellent heat resistance can be imparted to the first adhesive layer 11.

Each of the kind, the properties, and the ratio of the epoxy resin, the phenol resin, and the acrylic resin is described in the above-described known documents.

To prepare the first adhesive layer 11, the first particle and the first resin component are blended, thereby preparing the first adhesive resin composition. An additive (thermosetting catalyst, dispersant, rheology controlling agent, or the like) described in the above-described known documents can be also blended in the first adhesive resin composition. Also, the first adhesive resin composition can be prepared as a first adhesive resin composition solution that further contains a solvent. Then, the first adhesive resin composition solution is applied to the surface (the lower surface in FIG. 2D) of a peeling layer 10. Thereafter, the first adhesive resin composition solution is dried by heating, thereby removing the solvent. In this manner, the first adhesive layer 11 is disposed on the lower surface of the peeling layer 10. Preferably, the first adhesive layer 11 in a B-stage state is disposed on the lower surface of the peeling layer 10. To be specific, the first adhesive resin composition in an A-stage state is brought into a B-stage state by drying the first adhesive resin composition solution.

The peeling layer 10 is, for example, a flexible separator having a generally flat plate shape extending in the plane direction from a polymeric material such as polyethylene terephthalate (PET). The surface (the lower surface) of the peeling layer 10 is, for example, subjected to appropriate peeling treatment. The thickness of the peeling layer 10 is, for example, 15 μm or more, preferably 30 μm or more, and for example, 100 μm or less, preferably 75 μm or less.

The first adhesive layer 11 preferably has pressure-sensitive adhesive properties (tackiness).

The seed layer 19 is not yet in contact with the first adhesive layer 11 (described later), and a pressure-sensitive adhesive force PS3 (ref: FIG. 2F of the next step) of the seed layer 19 with respect to the first adhesive layer 11 is relatively high. Thus, the first peeling layer 2 can be surely peeled from the seed layer 19.

Accordingly, the following pressure-sensitive adhesive force PS satisfies, for example, the following formula.

$$PS1 < PS2 \leq PS3$$

PS1: pressure-sensitive adhesive force of the seed layer 19 with respect to the first peeling layer 2
PS2: pressure-sensitive adhesive force of the first adhesive layer 11 with respect to the coil pattern 5
PS3: pressure-sensitive adhesive force of the seed layer 19 with respect to the first adhesive layer 11

In this manner, as shown in FIG. 2D, the first adhesive layer 11 that is disposed on the lower surface of the peeling layer 10 is formed.

Next, the peeling layer 10 and the first adhesive layer 11 are disposed at the upper side of the coil pattern 5 so that the first adhesive layer 11 faces the coil pattern 5, and subsequently, as shown in FIG. 2E, the lower surface of the first adhesive layer 11 is brought into contact with the upper surface of the coil pattern 5. At this time, the first adhesive layer 11 is disposed with respect to the coil pattern 5 so that the lower surface of the first adhesive layer 11 is spaced apart from the upper surface of the seed layer 19 by the thickness of the coil pattern 5. That is, the seed layer 19 is not in contact with the first adhesive layer 11.

Thereafter, the seed layer 19 is press-bonded to the first adhesive layer 11, and the coil pattern 5 is pushed into the first adhesive layer 11. For example, the seed layer 19 is press-bonded to the first adhesive layer 11 by using a pressing machine such as vacuum pressing machine.

To be specific, the peeling layer 10, the first adhesive layer 11, the coil pattern 5, the seed layer 19, and the first peeling layer 2 are set in the pressing machine (not shown) including an upper board and a lower board. To be more specific, for example, the peeling layer 10 and the first adhesive layer 11 are set on the upper board, and the first peeling layer 2, the seed layer 19, and the coil pattern 5 are set on the lower board. Next, by driving the pressing machine, as shown by arrows of FIG. 2D, and FIG. 2F, the seed layer 19 is press-bonded with respect to the first adhesive layer 11, and the coil pattern 5 is pushed into the first adhesive layer 11. In this manner, the third step is performed.

In the press-bonding of the seed layer 19 with respect to the first adhesive layer 11, as shown in FIG. 2E, the upper surface of the coil pattern 5 is once in brought into contact with the lower surface of the first adhesive layer 11, and as shown in FIG. 2H, continuously, the coil pattern 5 is pushed into the first adhesive layer 11.

At this time, the coil pattern 5 is sunk into the first adhesive layer 11, and a portion of the first adhesive layer 11 that faces the coil pattern 5 in the thickness direction goes around the side of the coil pattern 5. Then, the side surfaces of the coil pattern 5 are covered with the first adhesive layer 11.

At the same time with this, the upper surface of the seed layer 19 is in contact with the lower surface of the first adhesive layer 11 in a portion other than the coil pattern 5.

At this time, the pressure-sensitive adhesive force PS3 of the seed layer 19 with respect to the first adhesive layer 11 is relatively high, so that the seed layer 19 pressure-sensitively adheres to the first adhesive layer 11.

In this manner, the lower surface of the coil pattern 5 and the lower surface of the first adhesive layer 11 are flush with each other to be continuous in the plane direction.

Thereafter, as shown by a phantom line and the arrow of FIG. 2F, the peeling layer 10 is peeled from the first adhesive layer 11.

In this manner, a first laminate 23 including the first peeling layer 2, the seed layer 19, the coil pattern 5, and the first adhesive layer 11 is obtained.

5. Fourth Step

As shown in FIG. 2H, in the fourth step, the lower surfaces of the coil pattern 5 and the first adhesive layer 11 are exposed.

The fourth step includes a fifth step (ref: FIG. 2G) of peeling the first peeling layer 2 from the seed layer 19 and a sixth step (ref: FIG. 2H) of removing the seed layer 19. The fifth step and the sixth step are sequentially performed in this order. Hereinafter, each of the fifth step and the sixth step is sequentially described.

5-1. Fifth Step

In the fifth step, as shown in FIG. 2G, the first peeling layer 2 is peeled from the seed layer 19.

To be specific, at the interface between the first peeling layer 2 and the seed layer 19, the first peeling layer 2 is peeled from the seed layer 19 (interfacial peeling). As described above, the pressure-sensitive adhesive force PS1 of the first peeling layer 2 with respect to the seed layer 19 is relatively low, so that the upper surface of the first peeling layer 2 is easily separated from the lower surface of the seed layer 19.

In this manner, a second laminate 24 including the seed layer 19, the coil pattern 5, and the first adhesive layer 11 is obtained.

5-2. Sixth Step

As shown in FIG. 2H, in the sixth step, the seed layer 19 is removed.

To remove the seed layer 19, for example, the seed layer 19 is etched.

Examples of the etching include wet etching and dry etching. In view of productivity, preferably, wet etching is used. In the wet etching, the above-described second laminate 24 is immersed in an etching solution.

The etching solution is not particularly limited as long as it is a solution that is capable of etching (eroding) the seed layer 19. Examples thereof include ferric chloride solution, and liquid mixture of sulfuric acid and hydrogen peroxide. Preferably, in view of etching the seed layer 19, and suppressing the etching of the lower surface of the coil pattern 5, a liquid mixture of sulfuric acid and hydrogen peroxide is used.

The etching time is, for example, 1 minute or more, preferably in view of surely removing the seed layer 19, 2 minutes or more, and for example, 10 minutes or less, preferably in view of suppressing the etching of the lower surface of the coil pattern 5, 5 minutes or less.

In the etching of the seed layer 19, the lower surface of the coil pattern 5 is not substantially removed by the etching. The slight etching of the coil pattern 5 is allowed, and for example, the etching of the lower end edge of the coil pattern 5 of 1 $\mu$m or less, furthermore, 0.1 $\mu$m or less is allowed.

By removing the seed layer 19 from the second laminate 24, the lower surfaces of the coil pattern 5 and the first adhesive layer 11 are exposed.

The lower surface of the coil pattern 5 and the lower surface of the first adhesive layer 11 form exposed surfaces that are exposed downwardly. The lower surface of the coil pattern 5 is exposed downwardly from the first adhesive layer 11.

In this manner, the first module 1 including the first adhesive layer 11 and the coil pattern 5 is produced. The lower surface of the first module 1, that is, the lower surfaces of the first adhesive layer 11 and the coil pattern 5 are exposed downwardly. The upper surface of the first module 1, that is, the upper surface of the first adhesive layer 11 is exposed upwardly. The first module 1 preferably consists of the first adhesive layer 11 and the coil pattern 5 only.

The first module 1 of the first embodiment is an intermediate member of a second module 31 (described later) in the second embodiment, does not include a second adhesive layer 12 (described later, ref: FIG. 4B), and is a member in which the first module 1 alone can be industrially available.

Thereafter, if necessary, when the first adhesive layer 11 is in a B-stage state, the first module 1 is heated, so that the first adhesive layer 11 is brought into a C-stage state.

The thickness of the first module 1 is, for example, 750 $\mu$m or less, preferably 500 $\mu$m or less, more preferably 300 $\mu$m or less, and for example, 10 $\mu$m or more. The thickness of the first module 1 is a distance between the lower surface of the coil pattern 5 and the upper surface of the first adhesive layer 11. When the thickness of the first module 1 is the above-described upper limit or less, the thinning of the first module 1 can be achieved.

The inductance of the first module 1 is, for example, 0.1 nH or more, preferably 0.5 nH or more, more preferably 1nH or more. The inductance is measured with an impedance analyzer (manufactured by Keysight Technologies, E4991B, 1 GHz). The subsequent inductance is measured by the same method as that described above.

<Uses of First Module>

The first module 1 obtained by the method for producing the first module 1 is, for example, used in wireless power transmission (wireless power feeding), wireless communication, a sensor, or the like. The lower surface of the coil pattern 5 is exposed, so that the first module 1 is preferably used in wireless power transmission and wireless communication.

<Function and Effect of First Embodiment>

(1) According to the method for producing the first module 1, the first module 1 without including the first insulating layer described in Patent Document 1 can be produced. Thus, the thinning of the first module 1 can be achieved. In the third step of the method for producing the first module 1, as shown in FIG. 2F, the coil pattern 5 is pushed into the first adhesive layer 11 containing the first magnetic particle, so that the further thinning of the first module 1 can be achieved, and high inductance can be ensured.

Furthermore, in the method for producing the first module 1, as shown in FIG. 2F, in the third step, the coil pattern 5 that is formed on the upper surface of the seed layer 19 is pushed into the first adhesive layer 11, and at this time, even though the upper surface of the seed layer 19 pressure-sensitively adheres to the first adhesive layer 11, as shown in FIGS. 2G and 2H, in the fourth step, when the first peeling layer 2 is peeled from the seed layer 19, and the seed layer 19 is etched, the lower surfaces of the coil pattern 5 and the first adhesive layer 11 can be surely and smoothly exposed.

(2) According to the method for producing the first module 1, as shown in FIG. 2F, in the third step, even though the seed layer 19 is press-bonded to the first adhesive layer 11, and the seed layer 19 pressure-sensitively adheres to the first adhesive layer 11, as shown in FIG. 2G, in the fifth step, the first peeling layer 2 is peeled from the seed layer 19, and as shown in FIG. 2H, in the sixth step, the seed layer 19 is removed, so that the lower surfaces of the coil pattern 5 and the first adhesive layer 11 can be further more surely and smoothly exposed.

(3) According to the method for producing the first module 1, as shown in FIG. 2F, in the third step, the coil pattern 5 that is formed on the upper surface of the seed layer 19 is pushed into the first adhesive layer 11, and at this time, even though the upper surface of the seed layer 19 is in tight contact with the first adhesive layer 11, as shown in FIG. 2H, in the sixth step, the seed layer 19 is etched, so that the seed layer 19 is surely and smoothly removed, and the lower surfaces of the coil pattern 5 and the first adhesive layer 11 can be further more surely and smoothly exposed.

(4) According to the method for producing the first module 1, when the content ratio of the first magnetic particle in the first adhesive layer 11 is 15 volume% or more, the improvement of the inductance can be achieved. Also, when the content ratio of the first magnetic particle in the first adhesive layer 11 is 80 volume% or less, the push-in of the coil pattern 5 with respect to the first adhesive layer 11 can be surely performed. Thus, both of the improvement of the inductance and the improvement of the push-in properties of the coil pattern 5 with respect to the first adhesive layer 11 can be achieved.

(5) According to the method for producing the first module 1, when the first resin component is the epoxy resin, the phenol resin, and the acrylic resin, as shown in FIG. 2F, in the third step, the coil pattern 5 can be surely pushed into the first adhesive layer 11, and the first module 1 having excellent flexibility and excellent heat resistance can be produced.

<Modified Example of First Embodiment>

In a modified example, the same reference numerals are provided for members and steps corresponding to each of those in the first embodiment, and their detailed description is omitted.

In the first embodiment, as shown in FIG. 1, the number of the coil pattern 5 is defined as 1. However, the number thereof is not particularly limited, and may be, for example, in plural.

As shown by the phantom lines of FIGS. 2G and 2H, the method for producing the first module 1 can further include a seventh step of disposing a magnetic layer 18 on the upper surface (one example of the other-side surface in the thickness direction) of the first adhesive layer 11.

In the seventh step, first, the magnetic layer 18 is prepared.

The magnetic layer 18 is a core material for focusing a magnetic field generated in the coil pattern 5, and amplifying a magnetic flux. The magnetic layer 18 is also a shield material for preventing a magnetic flux leakage to the outside of the coil pattern 5 (or shielding a noise from the outside of the coil pattern 5 with respect to the coil pattern 5). The magnetic layer 18 has a generally flat plate (sheet) shape extending in the plane direction.

The magnetic layer 18 contains a second magnetic particle and a second resin component. To be specific, the magnetic layer 18 is formed from a magnetic resin composition containing the second magnetic particle and the second resin component.

As the second magnetic particle, the same magnetic particle as that of the first magnetic particle is used, and preferably, in view of magnetic properties, a sendust (Fe-Si-Al alloy) particle is used. As the properties such as shape, holding strength, average particle size, and average thickness of the second magnetic particle, the properties described in the above-described known documents are used.

The volume ratio of the second magnetic particle in the magnetic layer 18 is, for example, 40 volume% or more, preferably 45 volume% or more, more preferably 48 volume% or more, further more preferably 60 volume% or more, and for example, 90 volume% or less, preferably 85 volume% or less, more preferably 80 volume% or less. When the volume ratio of the second magnetic particle is the above-described lower limit or more, the improvement of the inductance of the first module 1 can be further more achieved. When the volume ratio of the second magnetic particle is the above-described upper limit or less, the film-forming properties of the magnetic resin composition are excellent.

The mass ratio of the second magnetic particle in the magnetic layer 18 is, for example, 80 mass% or more, preferably 83 mass% or more, more preferably 85 mass% or more, and for example, 98 mass% or less, preferably 95 mass% or less, more preferably 90 mass% or less. When the mass ratio of the second magnetic particle is the above-described lower limit or more, the magnetic properties of the first module 1 are excellent. When the mass ratio of the second magnetic particle is the above-described upper limit or less, the magnetic resin composition is excellent.

As the second resin component, the same resin component as that of the first resin component is used. Preferably, the epoxy resin, the phenol resin, and the acrylic resin are used in combination. When the epoxy resin, the phenol resin, and the acrylic resin are used in combination as the second resin component, excellent flexibility and excellent heat resistance can be imparted to the magnetic layer 18.

To prepare the magnetic layer 18, the second magnetic particle and the second resin component are blended, thereby preparing the magnetic resin composition. An additive (thermosetting catalyst, dispersant, rheology controlling agent, or the like) described in the above-described known documents can be also blended in the magnetic resin composition. Also, the magnetic resin composition can be prepared as a magnetic resin composition solution that further contains a solvent. Then, the magnetic resin composition solution is applied to the surface of a peeling substrate that is not shown. Thereafter, the magnetic resin composition solution is dried by heating, thereby removing the solvent. In this manner, the magnetic layer 18 is prepared. Preferably, the magnetic layer 18 in a B-stage state is prepared.

Subsequently, when the magnetic layer 18 is in a B-stage state, the plurality of magnetic layers 18 are laminated in the thickness direction to be hot pressed in the thickness direction, so that the magnetic layer 18 in a C-stage state is formed. The lamination number of the magnetic layer 18 is not particularly limited, and for example, 2 or more, preferably 5 or more, and for example, 20 or less, preferably 10 or less. As the conditions of the hot pressing, the conditions described in the above-described known documents are appropriately used.

The average thickness of the magnetic layer 18 is, for example, 5 $\mu$m or more, preferably 10 $\mu$m or more, and for example, 500 $\mu$m or less, preferably 250 $\mu$m or less.

As shown by the phantom lines of FIGS. 2G and 2H, the magnetic layer 18 is brought into contact with the upper surface of the first adhesive layer 11. Preferably, the magnetic layer 18 is press-bonded to the first adhesive layer 11. For example, by using a pressing machine such as vacuum pressing machine, the magnetic layer 18 is attached to the first adhesive layer 11.

When the first adhesive layer 11 is in a B-stage state, the magnetic layer 18 pressure-sensitively adheres to the upper surface of the first adhesive layer 11. Thereafter, if necessary, the first adhesive layer 11 is brought into a C-stage state, and the magnetic layer 18 adheres to the first adhesive layer 11.

As shown by the phantom lines of FIG. 2H, the first module 1 of the modified example includes the first adhesive layer 11, the coil pattern 5, and the magnetic layer 18. Preferably, the first module 1 consists of the first adhesive layer 11, the coil pattern 5, and the magnetic layer 18 only.

In the seventh step, the magnetic layer 18 can be disposed on the first adhesive layer 11 of the second laminate 24 shown in FIG. 2G, or can be disposed on the first adhesive layer 11 shown in FIG. 2H.

In the modified example, the same function and effect as that of the first embodiment can be achieved.

(6) According to the method for producing the first module 1, as shown by the phantom line of FIG. 2G and the phantom line of FIG. 2H, in the seventh step, the magnetic layer 18 is disposed on the upper surface of the first adhesive layer 11, so that the inductance of the first module 1 can be further more improved.

In the third step of the first embodiment, the peeling layer 10 and the first adhesive layer 11 are set on the upper board, and the first peeling layer 2, the seed layer 19, and the coil pattern 5 are set on the lower board. However, the arrangement is not limited to this. For example, all of the peeling layer 10, the first adhesive layer 11, the first peeling layer 2, the seed layer 19, and the coil pattern 5 can be set on the upper board only. Alternatively, all of the peeling layer 10, the first adhesive layer 11, the first peeling layer 2, the seed layer 19, and the coil pattern 5 can be also set on the lower board only.

<Second Embodiment>

In the second embodiment, the same reference numerals are provided for members and steps corresponding to each of those in the first embodiment, and their detailed description is omitted.

As shown by the solid line of FIG. 2H, in the first embodiment, the first module 1 in which the lower surface of the coil pattern 5 is exposed is produced.

However, as shown in FIG. 4B, the method for producing the second module 31 of the second embodiment further includes an eighth step of embedding the coil pattern 5 by an adhesive layer 13 including the first adhesive layer 11 and the second adhesive layer 12 by covering the lower surface of the coil pattern 5 with the second adhesive layer 12.

Furthermore, as shown in FIG. 4D, the method for producing the second module 31 of the second embodiment further includes a ninth step of disposing each of the two magnetic layers 18 on the upper surface and the lower surface of the adhesive layer 13.

Hereinafter, the eighth step and the ninth step are sequentially described with reference to FIG. 3, and FIGS. 4A to 4D.

6. Eighth Step

As shown in FIG. 4B, in the eighth step, the lower surface of the coil pattern 5 is covered with the second adhesive layer 12.

As shown in FIG. 4A, the second adhesive layer 12 has a generally flat plate shape extending in the plane direction. The second adhesive layer 12 contains the same first magnetic particle and the same first resin component as those of the first adhesive layer 11. To be specific, the second adhesive layer 12 is formed from a second adhesive resin composition containing the first magnetic particle and the first resin component. The kind, the ratio, or the like of the first magnetic particle, the first resin component, and the additive in the second adhesive layer 12 are the same as those of the first magnetic particle and the first resin component in the first adhesive layer 11.

The thickness of the second adhesive layer 12 is, for example, 1 $\mu$m or more, preferably 3 $\mu$m or more, and for example, 100 $\mu$m or less, preferably 50 $\mu$m or less.

To prepare the second adhesive layer 12, the second adhesive resin composition is prepared. The second adhesive resin composition can be also prepared as a second adhesive resin composition solution that further contains a solvent. Then, the second adhesive resin composition solution is applied to the surface (the upper surface in FIG. 4A) of a second peeling layer 15. Thereafter, the second adhesive resin composition solution is dried by heating, thereby removing the solvent. In this manner, the second adhesive layer 12 is disposed on the upper surface of the second peeling layer 15. Preferably, the second adhesive layer 12 in a B-stage state is disposed on the upper surface of the second peeling layer 15. The second peeling layer 15 has the same shape, kind, and properties as those of the above-described peeling layer 10.

As shown in FIG. 4A, in this manner, the second adhesive layer 12 that is disposed on the upper surface of the second peeling layer 15 is formed.

Next, the second peeling layer 15 and the second adhesive layer 12 are disposed at the lower side of the first adhesive layer 11 and the coil pattern 5 so that the second adhesive layer 12 faces the lower surface (exposed surface) of the coil pattern 5 and the lower surface of the first adhesive layer 11. Subsequently, as shown in FIG. 4B, the upper surface of the second adhesive layer 12 is brought into contact with the lower surface (exposed surface) of the coil pattern 5 and the lower surface of the first adhesive layer 11. To be specific, when the second adhesive layer 12 is in a B-stage state, the second adhesive layer 12 pressure-sensitively adheres to the lower surface (exposed surface) of the coil pattern 5 and the lower surface of the first adhesive layer 11.

In this manner, the adhesive layer 13 including the first adhesive layer 11 and the second adhesive layer 12 is obtained. The content ratio of the first magnetic particle in the adhesive layer 13 is the same as the volume ratio of the first magnetic particle in the first adhesive layer 11.

The adhesive layer 13 embeds the coil pattern 5 (to be specific, the coil portion 6 shown by the phantom line of FIG. 3).

As shown in FIG. 3, the adhesive layer 13 exposes the lower surface of the terminal portion 7, while covering the lower surface of the coil portion 6. That is, the second adhesive layer 12 covers the coil portion 6 only in the coil pattern 5. On the other hand, the terminal portion 7 is exposed downwardly from the second adhesive layer 12, and in a state of still being pushed into the first adhesive layer 11.

In FIG. 4B, as depicted by a dashed line, the border between the first adhesive layer 11 and the second adhesive layer 12 can be viewed (visually observed) or observed with a microscope or the like. Or, there is a case where the above-described border cannot be viewed or observed.

In this manner, the eighth step of embedding the coil pattern 5 by the adhesive layer 13 is performed.

Thereafter, as shown by the arrow of FIG. 4B, and FIG. 4C, the second peeling layer 15 is peeled from the second adhesive layer 12 (the lower surface of the adhesive layer 13). Along with this, the peeling layer 10 is peeled from the second adhesive layer 12 (the upper surface of the first adhesive layer 11).

7. Ninth Step

As shown in FIG. 4D, in the ninth step, each of the two magnetic layers 18 is disposed on the upper surface and the lower surface of the adhesive layer 13.

As the magnetic layer 18, the magnetic layer 18 illustrated in the seventh step (ref: the phantom line of FIG. 2H) of the modified example of the first embodiment is used.

In the ninth step, as shown in FIG. 4C, the two magnetic layers 18 are prepared.

The volume ratio of the second magnetic particle in the magnetic layer 18 is high with respect to that of the first magnetic particle in the adhesive layer 13. Even in this case, as shown in FIG. 2F, while the coil pattern 5 can be surely pushed into the adhesive layer 13, as shown in FIG. 4C, after the magnetic layer 18 is formed into a sheet shape (preferably, a sheet shape in a C-stage state), as shown in FIG. 4D, the magnetic layer 18 can be attached to the upper surface and the lower surface of the adhesive layer 13 (preferably, the adhesive layer 13 in a B-stage state).

Subsequently, when the adhesive layer 13 is in a B-stage state, as shown by the arrows of FIG. 4C, each of the two magnetic layers 18 pressure-sensitively adheres to the upper surface and the lower surface of the adhesive layer 13.

Thereafter, if necessary, when the adhesive layer 13 is in a B-stage state, the second module 31 is heated, so that the adhesive layer 13 is brought into a C-stage state.

In this manner, as shown in FIG. 4D, the second module 31 including the adhesive layer 13, the coil pattern 5 having the coil portion 6 that is embedded in the adhesive layer 13, and the magnetic layer 18 that is disposed on the upper surface and the lower surface of the adhesive layer 13 is produced.

The thickness of the second module 31 is, for example, 1000 $\mu$m or less, preferably 700 $\mu$m or less, more preferably 500 $\mu$m or less, and for example, 50 $\mu$m or more. The thickness of the second module 31 is a distance between the upper surface and the lower surface of the adhesive layer 13. Also, the thickness of the second module 31 is the total sum of the thickness of the first module 1 in the first embodiment and the second adhesive layer 12. Furthermore, the thickness of the second module 31 is the total sum of the thickness of the coil pattern 5, a distance between the upper surface of the coil pattern 5 and the upper surface of the first adhesive layer 11 (the adhesive layer 13), and a distance between the lower surface of the coil pattern 5 and the lower surface of the second adhesive layer 12 (the adhesive layer 13).

The inductance of the second module 31 is, for example, 0.1 nH or more, preferably 0.5 nH or more, more preferably 1 nH or more.

8. Uses of Second Module of Second Embodiment

The coil pattern 5 is embedded in the adhesive layer 13, so that the second module 31 of the second embodiment is preferably used in a sensor.

<Function and Effect of Second Embodiment>

According to the second embodiment, the same function and effect as that of the first embodiment can be achieved (function and effect of (8), (9), (12), and (13)).

(7) According to the method for producing the second module 31, as shown in FIG. 4B, in the eighth step, the adhesive layer 13 that embeds the coil pattern 5 is formed, so that the inductance of the second module 31 can be further more improved.

(10) According to the method for producing the second module 31, as shown in FIG. 4D, in the ninth step, the magnetic layer 18 is disposed on the upper surface and the lower surface of the adhesive layer 13, so that the inductance of the second module 31 can be further more improved.

(11) According to the method for producing the second module 31, when the content ratio of the second magnetic particle in the magnetic layer 18 is high of 40 volume% or more, the improvement of the inductance can be further more achieved by the magnetic layer 18.

As shown in the central view of FIG. 4C, the second module 31 can also consist of the coil pattern 5 and the adhesive layer 13 that embeds the coil pattern 5 without including the magnetic layer 18. At this time, the method for producing the second module 31 does not include the ninth step shown in FIG. 4D.

<Modified Example of Second Embodiment>

In the modified example, the same reference numerals are provided for members and steps corresponding to each of those in the first and second embodiments, and their detailed description is omitted.

In the second embodiment, as shown in FIG. 3, the number of the coil pattern 5 is defined as 1. However, the number thereof is not particularly limited, and may be, for example, in plural. When the number of the coil pattern 5 is in plural, the second module 31 can be preferably used as a sensor.

<Third Embodiment>

In the third embodiment, the same reference numerals are provided for members and steps corresponding to each of those in the first and second embodiments, and their detailed description is omitted. The third embodiment can achieve the same function and effect as that described above.

As shown in FIG. 5A, in the third embodiment, the third module 33 includes a supporting layer 14 in addition to the coil pattern 5 and the first adhesive layer 11.

The supporting layer 14 is a substrate sheet (thin film) that supports the coil pattern 5 from the lower side thereof. The supporting layer 14 has a generally rectangular sheet shape when viewed from the top. The supporting layer 14 forms the lower surface of a third module 33. The supporting layer 14 is in contact with the lower surface of the coil pattern 5 and the lower surface of the first adhesive layer 11.

A material of the supporting layer 14 is a material having toughness, and examples thereof include resins such as polyimide, polyester, polyolefin, and fluorine resin. Preferably, polyimide is used. The thickness of the supporting layer 14 is, for example, 20 $\mu$m or less, preferably 10 $\mu$m or less, and for example, 0.1 $\mu$m or more, preferably 0.5 $\mu$m or more.

To obtain the third module 33, the supporting layer 14 is disposed on (attached to) the lower surface of the first module 1 of the first embodiment shown in FIG. 2H.

Thereafter, when the first adhesive layer 11 is in a B-stage state, the third module 33 is heated, or pressurized and heated, so that the first adhesive layer 11 is brought into a C-stage state.

The third module 33 of the third embodiment is an intermediate member of a fourth module 34 (described later) in the fourth embodiment, does not include the second adhesive layer 12 (described later, ref: FIG. 5B), and is a member in which the third module 33 alone can be industrially available.

<Function and Effect of Third Embodiment>

When the first adhesive layer 11 is in a B-stage state, and the first adhesive layer 11 is brought into a C-stage state by heating the third module 33, a stress from the outside is imparted from the first adhesive layer 11 to the coil pattern 5 by the stress (heat shrinkage force) or pressurization, and thus, the position displacement in the plane direction of the coil pattern 5 easily occurs. In this case, the third module 33 having the inductance that is displaced from the inductance originally designed caused by the position displacement of the coil pattern 5 is obtained.

However, according to the method for producing the third module 33, the coil pattern 5 is supported by the supporting layer 14, so that the position displacement of the coil pattern 5 in the process of the above-described C-stage state can be suppressed, and the position accuracy of the coil pattern 5 can be improved. Thus, the above-described displacement of the inductance is prevented, and the third module 33 having the inductance originally designed can be produced.

<Fourth Embodiment>

In the fourth embodiment, the same reference numerals are provided for members and steps corresponding to each of those in the first to third embodiments, and their detailed description is omitted. The fourth embodiment can achieve the same function and effect as that described above.

As shown in FIG. 5A, in the third embodiment, the third module 33 in which the lower surface of the supporting layer 14 is exposed is produced.

However, as shown in FIG. 5D, the method for producing the fourth module 34 of the fourth embodiment further includes an eleventh step of sandwiching the coil pattern 5 and the supporting layer 14 in the thickness direction by the adhesive layer 13 that includes the first adhesive layer 11 and the second adhesive layer 12 by covering the lower surface of the supporting layer 14 with the second adhesive layer 12.

Furthermore, as shown in FIG. 5D, the method for producing the fourth module 34 of the fourth embodiment further includes a twelfth step of disposing each of the two magnetic layers 18 on the upper surface and the lower surface of the adhesive layer 13.

As shown by the arrows of FIG. 5A, and FIG. 5B, in the eleventh step, the lower surface of the supporting layer 14 is covered with the second adhesive layer 12. The adhesive layer 13 that includes the first adhesive layer 11 and the second adhesive layer 12 is obtained. In this manner, the coil pattern 5 and the supporting layer 14 are sandwiched in the up-down direction by the adhesive layer 13.

Thereafter, as shown by the arrows of FIG. 5B, a third peeling layer 15 is peeled from the second adhesive layer 12 (the lower surface of the adhesive layer 13). Along with this, the peeling layer 10 is peeled from the first adhesive layer 11 (the upper surface of the adhesive layer 13).

As shown by the arrows of FIG. 5C, and FIG. 5D, in the twelfth step, each of the two magnetic layers 18 is disposed on the upper surface and the lower surface of the adhesive layer 13.

In the twelfth step, as shown in FIG. 5C, the two magnetic layers 18 are prepared. Subsequently, when the adhesive layer 13 is in a B-stage state, as shown by the arrows of FIG. 5C, each of the two magnetic layers 18 pressure-sensitively adheres to the upper surface and the lower surface of the adhesive layer 13.

Thereafter, if necessary, when the adhesive layer 13 is in a B-stage state, the fourth module 34 is heated, or pressurized and heated, so that the adhesive layer 13 is brought into a C-stage state.

In this manner, as shown in FIG. 5D, the fourth module 34 including the adhesive layer 13, the coil pattern 5 and the supporting layer 14 sandwiched in the thickness direction of the adhesive layer 13, and the magnetic layer 18 that is disposed on the upper surface and the lower surface of the adhesive layer 13 is produced.

According to the method for producing the fourth module 34, as shown in FIG. 5B, in the eleventh step, the adhesive layer 13 that sandwiches the coil pattern 5 and the supporting layer 14 therebetween is formed, so that the inductance of the fourth module 34 can be further more improved, while the position accuracy of the coil pattern 5 is improved.

Examples

Next, the present invention is described based on Examples and Comparative Examples. The present invention is however not limited by these Examples and Comparative Examples. The specific numerical values in mixing ratio (content ratio), property value, and parameter used in the following description can be replaced with upper limit values (numerical values defined as "or less" or "below") or lower limit values (numerical values defined as "or more" or "above") of corresponding numerical values in mixing ratio (content ratio), property value, and parameter described in the above-described "DESCRIPTION OF EMBODIMENTS".

Example 1

(Example Corresponding to Second Embodiment)

(First Step)

As shown in FIG. 2A, the seed layer 19 having a thickness of 1.5 $\mu$m and made of copper was formed on the upper surface of the first peeling layer 2 having a thickness of 50 $\mu$m and made of stainless steel (SUS 304) by electrolytic plating.

In this manner, the first step of preparing the seed layer 19 that was defined as the upper surface of the first peeling layer 2 was performed.

(Second Step)

Next, as shown in FIG. 2D, the coil pattern 5 was formed by plating allowing electric power to be supplied from the seed layer 19.

To be specific, the coil pattern 5 was formed by an additive method. That is, first, as shown in FIG. 2B, a photoresist was disposed on the entire upper surface of the seed layer 19. Next, the photoresist was subjected to photo processing, so that as shown in FIG. 1A, the plating resist 29 having a pattern reverse to the coil pattern 5 was disposed on the upper surface of the seed layer 19. Subsequently, as shown in FIG. 2C, the coil pattern 5 was formed in a portion that was exposed from the plating resist 29 on the upper surface of the seed layer 19 by the plating allowing the electric power to be supplied from the seed layer 19. Subsequently, as shown in FIG. 2D, the plating resist 29 was peeled.

In this manner, the second step of forming the peeling layer 10 on the upper surface of the seed layer 19 was performed.

As shown in FIG. 1, the coil pattern 5 continuously had the coil portion 6 having an inside dimension L1 of 1900 μm, an outside dimension L2 of 3100 μm, a width W1 of 600 μm, and a distance L3 between the two rear end portions thereof of 600 μm, and the two terminal portions 7 having a width W2 of 200 μm.

(Third Step)

As shown in FIG. 2F, next, the coil pattern 5 was pushed into the first adhesive layer 11.

To be specific, first as shown in FIG. 2D, the first adhesive layer 11 was prepared.

To prepare the first adhesive layer 11, first, each of the components was blended in accordance with Table 1 to prepare an adhesive resin composition (first adhesive resin composition), and subsequently, the adhesive resin composition was dissolved in methyl ethyl ketone, so that an adhesive resin composition solution having the solid content concentration of 35 mass% was prepared. Next, the adhesive resin composition solution was applied to the surface of the peeling layer 10 (model number: "MRA50", manufactured by Mitsubishi Plastics, Inc.) having a thickness of 50 μm and made of PET to be thereafter dried at 110°C for 2 minutes. In this manner, as shown in FIG. 2D, the first adhesive layer 11 in a B-stage state having an average thickness of 45 μm was formed.

Next, the peeling layer 10 and the first adhesive layer 11 were disposed at the upper side of the coil pattern 5 so that the first adhesive layer 11 faced downwardly. To be specific, the peeling layer 10 and the first adhesive layer 11 were disposed on the upper board of the vacuum pressing machine, and the first peeling layer 2, the seed layer 19, and the coil pattern 5 were disposed on the lower board thereof. Subsequently, the vacuum pressing machine was driven, and as shown in FIG. 2F, the seed layer 19 was press-bonded to the first adhesive layer 11, so that the coil pattern 5 was pushed into the first adhesive layer 11. In the press-bonding of the seed layer 19 with respect to the first adhesive layer 11, as shown in FIG. 2E, the upper surface of the coil pattern 5 was once brought into contact with the lower surface of the first adhesive layer 11. Continuously, as shown in FIG. 2F, the upper surface of the coil pattern 5 was pushed into the first adhesive layer 11. At this time, the seed layer 19 and the first adhesive layer 11 were in contact with each other in a portion other than the coil pattern 5.

(Fourth Step)

(Fifth Step and Sixth Step)

In the fourth step, as shown in FIGS. 2G and 2H, the lower surfaces of the coil pattern 5 and the first adhesive layer 11 were exposed.

To be specific, first, as shown in FIG. 2G, the fifth step (ref: FIG. 2G) of peeling the first peeling layer 2 from the seed layer 19 and the sixth step (ref: FIG. 2H) of removing the seed layer 19 were sequentially performed.

In the fifth step, the first peeling layer 2 was peeled from the lower surface of the seed layer 19 so that an interfacial peeling occurred between the first peeling layer 2 and the seed layer 19.

In the sixth step, the seed layer 19 was removed by the etching. In the etching of the seed layer 19, as the etching solution, a liquid mixture of sulfuric acid and hydrogen peroxide was used, and the etching time was 3 minutes.

In this manner, as shown in FIG. 4A, the lower surface of the coil pattern 5 was exposed downwardly from the first adhesive layer 11.

In this manner, the fourth step was performed.

In this manner, as shown in FIG. 4A, the first module 1 was obtained as an intermediate member for obtaining the second module 31 to be described later. The first module 1 included the first adhesive layer 11, and the coil pattern 5 that was pushed into the first adhesive layer 11, and was supported (protected) by the peeling layer 10.

(Eighth Step)

Next, as shown in FIG. 4B, the lower surface of the coil pattern 5 was covered with the second adhesive layer 12 so as to expose the lower surface of the terminal portion 7.

To be specific, as shown in FIG. 4A, the second adhesive layer 12 was prepared on the upper surface of the second peeling layer 15 in accordance with the same method as that of the first adhesive layer 11 in a B-stage state having an average thickness of 40 $\mu$m. Next, as shown by the arrows of FIG. 4A, and FIG. 4B, the upper surface of the second adhesive layer 12 pressure-sensitively adhered to the lower surface of the coil portion 6 and the lower surface of the first adhesive layer 11. In this manner, the eighth step of forming the adhesive layer 13 including the first adhesive layer 11 and the second adhesive layer 12, and embedding the coil portion 6 was performed.

Thereafter, as shown by the arrow at the lower side of FIG. 4B, the peeling layer 10 was peeled from the first adhesive layer 11. Also, as shown by the arrow at the upper side of FIG. 4B, the second peeling layer 15 was peeled from the second adhesive layer 12.

(Ninth Step)

As shown in FIG. 4D, the magnetic layer 18 was disposed on the upper surface and the lower surface of the adhesive layer 13.

To be specific, first, in accordance with Table 1, each of the components was blended to prepare a magnetic resin composition, and subsequently, the magnetic resin composition was dissolved in methyl ethyl ketone, so that a magnetic resin composition solution having the solid content concentration of 45 mass% was prepared. Next, the magnetic resin composition solution was applied to a peeling substrate that was not shown to be thereafter dried at 110°C for 2 minutes. In this manner, the magnetic layer 18 (average thickness of 45 $\mu$m) in a B-stage state was prepared. Thereafter, the magnetic layer 18 was peeled from the peeling substrate, and the eight layers of magnetic layers 18 were laminated to be heated and cured by hot pressing under the conditions of 175°C, 30 minutes, and 10 MPa. In this manner, as shown in FIG. 4C, the magnetic layer 18 in a C-stage state (average thickness of 200 $\mu$m) was fabricated.

By using the vacuum pressing machine, each of the two magnetic layers 18 pressure-sensitively adhered (was attached) to the upper surface of the adhesive layer 13 (the upper surface of the first adhesive layer 11) and the lower surface thereof (the lower surface of the second adhesive layer 12). In this manner, the ninth step was performed.

In this manner, the second module 31 including the adhesive layer 13, the coil pattern 5 having the coil portion 6 that was embedded in the adhesive layer 13, and the magnetic layer 18 that was disposed on the upper surface and the lower surface of the adhesive layer 13 was produced.

Thereafter, the adhesive layer 13 in a B-stage state was brought into a C-stage state.

(Examples 2 to 6 and Comparative Example 1)

The first module 1 was produced, and subsequently, the second module 31 was produced in the same manner as that of Example 1, except that the adhesive resin composition was changed in accordance with Table 1.

(Comparative Example 2)

As shown in FIG. 6A, the second module 31 was produced in the same manner as that of Example 1, except that the coil pattern 5 was formed on the upper surface of a peeling layer 45 by a subtractive method.

To be specific, as shown in FIG. 6A, first, the pressure-sensitive peeling layer 45 was prepared, next, a conductive layer having a thickness of 50 $\mu$m and made of copper was disposed on the upper surface of the peeling layer 45, and next, the coil pattern 5 was formed by the etching.

As shown in FIG. 6B, next, the coil pattern 5 was pushed into the first adhesive layer 11. At this time, the peeling layer 45 pressure-sensitively adhered to the first adhesive layer 11.

As shown by the phantom line of FIG. 6B, the peeling layer 45 was tried to be peeled from the lower surfaces of the coil pattern 5 and the first adhesive layer 11.

However, the above-described peeling could not be performed because of the pressure-sensitive adhesion of the peeling layer 45 and the first adhesive layer 11, so that the peeling layer 45 was subjected to cohesive failure.

[Table 1]

Table 1

| | | | | Ex. 1 | Ex. 2 | Ex. 3 | Ex. 4 | Ex. 5 | Ex. 6 | Comp. Ex. 1 | Comp. Ex. 2 |
|---|---|---|---|---|---|---|---|---|---|---|---|
| Adhesive Layer | Soft Magnetic Particle | Ni-Zn Ferrite Particle | [parts by mass] | 44.68 | 75.36 | - | - | - | - | - | 44.68 |
| | | Fe-Si-Cr Alloy Particle | [parts by mass] | - | - | 81.70 | 90.97 | 93.98 | 94.61 | - | - |
| | | | volume% | 15.0 | 40.0 | 40.0 | 60.0 | 70.0 | 80.0 | - | 15.0 |
| | Adhesive Resin Composition (First Adhesive Resin Composition) (Second Adhesive Resin Composition) | Epoxy Resin — Cresol Novolak Epoxy Resin | [parts by mass] | 5.16 | 2.29 | 1.70 | 0.84 | 0.55 | 0.33 | 9.34 | 5.16 |
| | | Epoxy Resin — Bisphenol A Epoxy Resin | [parts by mass] | 14.01 | 6.23 | 4.62 | 2.27 | 1.50 | 0.89 | 25.34 | 14.01 |
| | | Phenol Resin — Phenol Biphenylene Resin | [parts by mass] | 21.07 | 9.36 | 6.94 | 3.41 | 2.26 | 1.33 | 38.11 | 21.07 |
| | | Acrylic Resin — Modified Ethyl Acrylate-Butyl Acrylate-Acrylonitrile Copolymer | [parts by mass] | 14.49 | 6.44 | 4.78 | 2.34 | 1.55 | 0.92 | 26.22 | 14.49 |
| | | Additive — Thermosetting Catalyst | [parts by mass] | 0.55 | 0.24 | 0.18 | 0.09 | 0.06 | 0.03 | 0.99 | 0.55 |
| | | Additive — Dispersant | [parts by mass] | 0.04 | 0.08 | 0.08 | 0.09 | 0.09 | 0.10 | - | 0.04 |
| Forming Method of Coil Pattern | | | | Additive Method | Additive Method | Additive Method | Additive Method | Additive Method | Additive Method | Additive Method | Subtractive Method |

(continued)

| Table 1 | | | | | Ex. 1 | Ex. 2 | Ex. 3 | Ex. 4 | Ex. 5 | Ex. 6 | Comp. Ex. 1 | Comp. Ex. 2 |
|---|---|---|---|---|---|---|---|---|---|---|---|---|
| Ex. Comparative Ex. | | | | | Ex. 1 | Ex. 2 | Ex. 3 | Ex. 4 | Ex. 5 | Ex. 6 | Comp. Ex. 1 | Comp. Ex. 2 |
| Magnetic Layer | Magnetic Resin Composition | Soft Magnetic Particle | Fe-Si-Al Alloy Particle | [parts by mass] | 90.32 | 90.32 | 90.32 | 90.32 | 90.32 | 90.32 | 90.32 | Peeling Layer Cannot Be Peeled, Arrangement and Evaluation of Magnetic Layer is Not Possible |
| | | | | volume% | 60.0 | 60.0 | 60.0 | 60.0 | 60.0 | 60.0 | 60.0 | |
| | | Epoxy Resin | Cresol Novolak Epoxy Resin | [parts by mass] | 2.55 | 2.55 | 2.55 | 2.55 | 2.55 | 2.55 | 2.55 | |
| | | Phenol Resin | Phenol Biphenylene Resin | [parts by mass] | 2.60 | 2.60 | 2.60 | 2.60 | 2.60 | 2.60 | 2.60 | |
| | | Acrylic Resin | Modified Ethyl Acrylate-Butyl Acrylate-Acrylonitrile Copolymer | [parts by mass] | 4.16 | 4.16 | 4.16 | 4.16 | 4.16 | 4.16 | 4.16 | |
| | | Additive | Thermosetting Catalyst | [parts by mass] | 0.09 | 0.09 | 0.09 | 0.09 | 0.09 | 0.09 | 0.09 | |
| | | | Dispersant | [parts by mass] | 0.09 | 0.09 | 0.09 | 0.09 | 0.09 | 0.09 | 0.09 | |
| | | Rheology Controlling Agent | | [parts by mass] | 0.19 | 0.19 | 0.19 | 0.19 | 0.19 | 0.19 | 0.19 | |
| Evaluation | | Push-in Properties of Coil Pattern to First Adhesive Layer | | | Excellent | Excellent | Excellent | Excellent | Excellent | Good | Excellent | |
| | | Magnetic Permeability of Second Module | | | 2 | 4 | 5 | 9 | 15 | 16 | 1 | |
| | | Inductance of Second Module | | [nH] | 26 | 37 | 42 | 58 | 66 | 70 | 18 | |

The details of each of the components described in Table 1 were described in the following.

Ni-Zn ferrite particle: soft magnetic particle, manufactured by JFE FERRITE Co., Ltd., model number: KNI-109, average particle size of 1.5 $\mu$m

Fe-Si-Cr alloy particle: soft magnetic particle, manufactured by NIPPON ATOMIZED METAL POWDERS, Inc., average particle size of 8 $\mu$m, trade name (iron alloy powders SFR-FeSiCr)

Fe-Si-Al alloy particle: soft magnetic particle, flat, coercive force in easy direction of magnetization of 3.9 (Oe), average particle size of 40 $\mu$m, average thickness of 1 $\mu$m

Cresol novolak epoxy resin: epoxy equivalent of 199 g/eq., ICI viscosity (150°C) of 0.4 Pa·s, specific gravity of 1.21, trade name: "KI-3000-4", manufactured by Tohto Kasei Co., Ltd.

Bisphenol A epoxy resin: epoxy equivalent: 180 g/eq., ICI viscosity (150°C) of 0.05 Pa·s, specific gravity of 1.15, trade name: "EPIKOTE YL980", manufactured by Mitsubishi Chemical Corporation

Phenol biphenylene resin: hydroxyl group equivalent of 203 g/eq., ICI viscosity (150°C) of 0.05 Pa·s, specific gravity of 1.18, trade name: "MEH-7851SS", manufactured by MEIWA PLASTIC INDUSTRIES, LTD.

Acrylic resin: carboxy group and hydroxy group-modified ethyl acrylate-butyl acrylate-acrylonitrile copolymer, weight average molecular weight of 900,000, specific gravity of 1.00, trade name: "TEISANRESIN SG-70L" (resin content ratio of 12.5 mass%), manufactured by Nagase ChemteX Corporation

Thermosetting catalyst: 2-phenyl-1H-imidazole 4,5-dimethanol, specific gravity of 1.33, trade name: "CUREZOL 2PHZ-PW", manufactured by SHIKOKU CHEMICALS CORPORATION

Dispersant: polyether phosphoric ester, acid value of 17, specific gravity of 1.03, trade name: "HIPLAAD ED152", manufactured by Kusumoto Chemicals, Ltd.

The adhesive resin composition was prepared in accordance with the description of Table 1.

(Evaluation)

Each of the items was evaluated as to each of the second modules 31 of Examples and Comparative Examples (except for Comparative Example 2). The results are shown in Table 1.

1. Push-in Properties of Coil Pattern to First Adhesive Layer

The push-in properties of the coil pattern 5 with respect to the first adhesive layer 11 in the third step shown in FIG. 2H were evaluated based on the following criteria.

Excellent: the coil pattern 5 was surely pushed into the first adhesive layer 11.

Good: the coil pattern 5 was pushed into the first adhesive layer 11, but the yield was 50 %.

2. Magnetic Permeability and Inductance

The magnetic permeability was measured with a one-turn method (frequency: 10 MHz) by using an impedance analyzer (manufactured by Keysight Technologies, "E4991B", 1 GHz model).

The inductance was measured with an impedance analyzer (manufactured by Keysight Technologies, "E4991B", 1 GHz model).

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

Industrial Applicability

By the method for producing a module, a module used in wireless power transmission (wireless power feeding), wireless communication, a sensor, or the like is produced.

Description of Reference Numerals

1    First module
2    First peeling layer
3    Conductive layer
5    Coil pattern
9    Second peeling layer

11    First adhesive layer
12    Second adhesive layer
13    Adhesive layer
18    Magnetic layer
19    Seed Layer 19
31    Second module

**Claims**

1.  A method for producing a module comprising:

    a first step of preparing a seed layer disposed at a one-side surface in a thickness direction of a first peeling layer,
    a second step of forming a conductive pattern at a one-side surface in the thickness direction of the seed layer by plating allowing electric power to be supplied from the seed layer,
    a third step of pushing the conductive pattern into a first adhesive layer containing a first magnetic particle, and
    a fourth step of exposing the other-side surfaces in the thickness direction of the conductive pattern and the first adhesive layer.

2.  The method for producing a module according to claim 1, wherein
    in the third step, the seed layer is press-bonded to the first adhesive layer, and the conductive pattern is pushed into the first adhesive layer, and
    the fourth step includes a fifth step of peeling the first peeling layer from the seed layer and a sixth step of removing the seed layer.

3.  The method for producing a module according to claim 2, wherein
    in the sixth step, the seed layer is etched.

4.  The method for producing a module according to claim 1, wherein
    the content ratio of the first magnetic particle in the first adhesive layer is 15 volume% or more and 80 volume% or less.

5.  The method for producing a module according to claim 1, wherein
    a first resin component is an epoxy resin, a phenol resin, and an acrylic resin.

6.  The method for producing a module according to claim 1 further comprising:
    a seventh step of disposing a magnetic layer containing a second magnetic particle and a second resin component at the other-side surface in the thickness direction of the first adhesive layer.

7.  The method for producing a module according to claim 1 further comprising:

    an eighth step of forming an adhesive layer including the first adhesive layer and the second adhesive layer and embedding the conductive pattern by covering the one-side surface in the thickness direction of the conductive pattern with a second adhesive layer containing the first magnetic particle, wherein
    the fourth step is performed so that the one-side surface in the thickness direction of the conductive pattern is exposed from the first adhesive layer.

8.  The method for producing a module according to claim 7, wherein
    the content ratio of the first magnetic particle in the adhesive layer is 15 volume% or more and 80 volume% or less.

9.  The method for producing a module according to claim 1, wherein
    the first magnetic particle is a particle consisting of at least one kind selected from iron and iron alloy.

10. The method for producing a module according to claim 7 further comprising:
    a ninth step of disposing the magnetic layer containing the second magnetic particle and the second resin component at the one-side surface and the other-side surface in the thickness direction of the adhesive layer.

11. The method for producing a module according to claim 6, wherein
    the content ratio of the second magnetic particle in the magnetic layer is 40 volume% or more.

**12.** The method for producing a module according to claim 6, wherein
the second magnetic particle is a particle consisting of at least one kind selected from iron and iron alloy.

**13.** The method for producing a module according to claim 6, wherein
the second resin component is an epoxy resin, a phenol resin, and an acrylic resin.

FIG. 1

right-left direction

rear side

left side ← → right side

front side

front-rear direction

FIG. 2A
First step

FIG. 2E

FIG. 2B

FIG. 2F
Third step

FIG. 2C

FIG. 2G
Fourth step (Fifth step)

FIG. 2D
Second step

FIG. 2H
Sixth step (Seventh step)

FIG. 3

13

12    11                                  7

                                            5

                                         6

31

right-left direction

rear side

left side ←→ right side

front side

front-rear direction

FIG. 4A

FIG. 4B
Eighth step

FIG. 4C

FIG. 4D
Ninth step

31

FIG. 5A

1 { 11, 5(6) }
10
33
5(6)
14

12
15

FIG. 5B

5(6)
10
33
5(6)
13 { 11, 12 }
14
15

FIG. 5C

18

5(6)
33
5(6)
13 { 11, 12 }
14
(31)

18

FIG. 5D
Ninth step

5(6)
18
11
13 { 11, 12 }
5(6)
14
18

34

FIG. 6A

FIG. 6B

## INTERNATIONAL SEARCH REPORT

| International application No. |
| --- |
| PCT/JP2017/041229 |

**A. CLASSIFICATION OF SUBJECT MATTER**
Int.Cl. H01F41/04(2006.01)i, H01F17/00(2006.01)i, H05K1/16(2006.01)i, H05K3/20(2006.01)i

According to International Patent Classification (IPC) or to both national classification and IPC

**B. FIELDS SEARCHED**

Minimum documentation searched (classification system followed by classification symbols)
Int.Cl. H01F41/04, H01F17/00, H05K1/16, H05K3/20

Documentation searched other than minimum documentation to the extent that such documents are included in the fields searched
| | |
| --- | --- |
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2004-241538 A (MATSUSHITA ELECTRIC INDUSTRIAL CO., LTD.) 26 August 2004, paragraphs [0018]-[0039], fig. 1-4(f) (Family: none) | 1-13 |
| A | JP 8-162352 A (MATSUSHITA ELECTRIC INDUSTRIAL CO., LTD.) 21 June 1996, paragraphs [0116]-[0131], fig. 11(a)-12(e) & JP 2003-17351 A & US 5647966 A, paragraph 11, line 20 to paragraph 14, line 47, fig. 11A-12E & EP 706310 A1 & EP 1180919 A2 & DE 69527334 T & KR 10-0276052 B & CN 1130291 A | 1-13 |

☒ Further documents are listed in the continuation of Box C.     ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 24 January 2018 | 06 February 2018 |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
| --- | --- |

Form PCT/ISA/210 (second sheet) (January 2015)

**INTERNATIONAL SEARCH REPORT**

| International application No. |
|---|
| PCT/JP2017/041229 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2008-166407 A (TDK CORPORATION) 17 July 2008, paragraphs [0014]-[0022], fig. 1-8 (Family: none) | 1-13 |
| A | JP 2004-327612 A (TDK CORPORATION) 18 November 2004, paragraphs [0016]-[0029], fig. 1(A)-2(B) (Family: none) | 1-13 |

Form PCT/ISA/210 (continuation of second sheet) (January 2015)

**REFERENCES CITED IN THE DESCRIPTION**

**Patent documents cited in the description**

- JP H1318212 B
- JP 2016108561 A
- JP 2016006853 A
- JP 2016006852 A
- JP 2016006163 A